# EUROPEAN PATENT APPLICATION

(11) **EP 2 071 719 A2**
(43) Date of publication of application: **17.06.2009**
(21) Application number: 08021003.2
(22) Date of filing: 03.12.2008
(51) Int. Cl.: H03D 5/00

(54) **Signal receiver, control method thereof, and signal receiving module**

(30) Priority: 11.12.2007 JP 2007319198
(71) Applicant: Alps Electric Co., Ltd., Tokyo 145-8501 (JP)
(72) Inventor: Obara, Katsutoshi, Tokyo, 145-8501 (JP)
(74) Representative: Klunker . Schmitt-Nilson . Hirsch

(57) **Abstract**

A signal receiver (100) includes: a receiving unit (111) that receives an analog modulation signal and a digital modulation signal; a digital demodulation circuit (112) that demodulates the digital modulation signal; a first control circuit (113) that performs communication with the digital demodulation circuit (112) through a first dedicated control line (B11A) ; and a second control circuit (121) that performs communication with the first control circuit (113) through a second dedicated control line (B11B). The second control circuit (121) stops the communication between the digital demodulation circuit (112) and the first control circuit (113) before switching from reception of the digital modulation signal to reception of the analog modulation signal and stops supply of power to the digital demodulation circuit (112) after checking through the second dedicated control line (B11B) that the communication has stopped.

## Description

### Cross Reference to Related Applications

The present application contains subject matter related to Japanese Patent Application JP2007-319198 filed in the Japanese Patent Office on December 11, 2007, the entire contents of which being incorporated herein by reference.

### BACKGROUND

### 1. Technical Field

The present invention relates to a signal receiver, a control method thereof, and a signal receiving module. More specifically, the invention relates to a signal receiver that switches and receives an analog modulation wave and a digital modulation wave, a control method thereof, and a signal receiving module.

### 2. Related Art

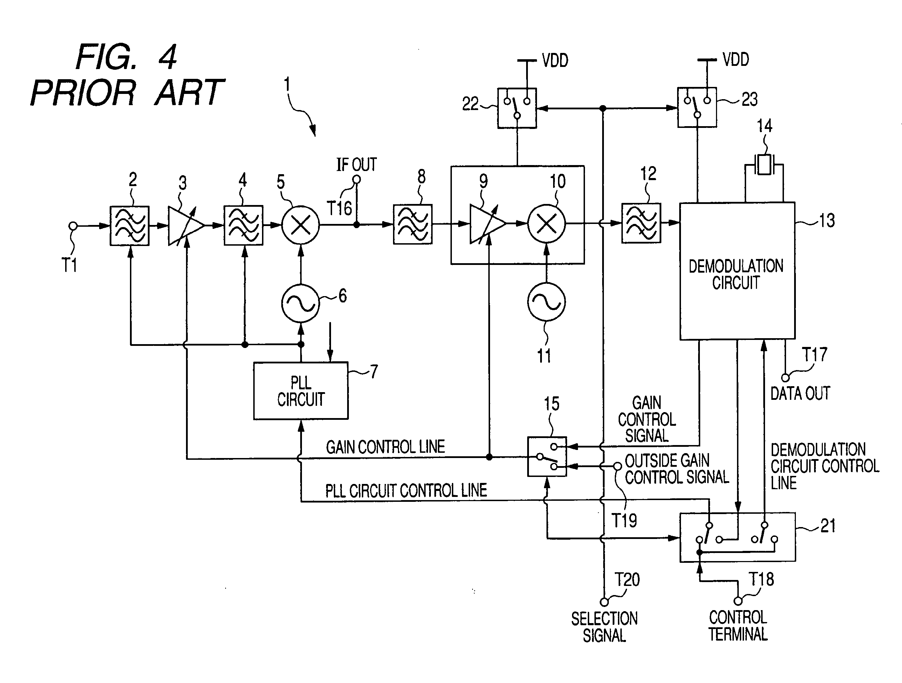

As a known signal receiver, for example, as a receiver that receives a television signal, there is a receiver that receives an analog modulation television signal and a digital modulation television signal (refer to Japanese Unexamined Patent Application Publication No. 2000-224061). Fig. 4 is a block diagram showing the configuration of a known broadcasting receiver 1. As shown in Fig. 4, in the broadcasting receiver 1, a receiving terminal T1 is a terminal which receives a broadcast signal in which an analog modulation wave and a digital modulation wave are mixed. Band pass filters 2, 4, and 8 allow a signal, which belongs to a desired frequency range, among input signals, to pass therethrough. Particularly the band pass filters 2 and 4 are variable band pass filters in which the center frequency of a pass band varies by the control of a PLL circuit 7 which will be described later.

A low pass filter 12 allows only a signal equal to or smaller than a specific frequency among input signals to pass therethrough. A high frequency amplifier 3 is a variable gain amplifier which amplifies a signal output from the band pass filter 2, and an intermediate frequency amplifier 9 is a variable gain amplifier which amplifies an intermediate frequency (IF) signal output from the band pass filter 8.

A mixer 5 converts a signal output from the band pass filter 4 into an IF signal using a signal of a signal source 6 a phase of which is controlled in the PLL circuit 7. An output terminal T16 is an (IF OUT) terminal which takes out an intermediate frequency output from the mixer 5 in receiving an analog broadcast signal. A mixer 10 converts an output signal from an intermediate frequency amplifier 9 into a second intermediate frequency signal using a signal of a signal source 11. A demodulation circuit 13 operates by a control signal, which is input from a control terminal T18 through a control line selection circuit 21 and a demodulation circuit control line, and a clock signal generated in a crystal oscillator 14, demodulates a digital modulation signal output from the low pass filter 12, and outputs (DATA OUT) the demodulated signal as demodulated data from an output terminal T17.

In addition, the demodulation circuit 13 outputs a gain control signal. In case of controlling a gain of the high frequency amplifier 3 and a gain of the intermediate frequency amplifier 9 using the gain control signal, a gain control line selection circuit 15 connects the demodulation circuit 13, the high frequency amplifier 3, and the intermediate frequency amplifier 9 with each other such that the gain control signal is input to the high frequency amplifier 3 and the intermediate frequency amplifier 9 on the basis of a selection signal input from an external terminal T20, thereby making the gain control line selective.

When the gain control signal is supplied from the outside, the gain control line selection circuit 15 connects an external terminal T19, the high frequency amplifier 3, and the intermediate frequency amplifier 9 with each other such that an external gain control signal is input to the high frequency amplifier 3 and the intermediate frequency amplifier 9 on the basis of the selection signal input from the external terminal T20, thereby making the gain control line selective. In addition, the demodulation circuit 13 is connected to the PLL circuit 7 through the control line selection circuit 21 and a PLL circuit control line and controls an operation of the PLL circuit 7.

In addition, a circuit configured to include the intermediate frequency amplifier 9 and the mixer 10 and the demodulation circuit 13 are connected to a power line VDD through power control circuits 22 and 23.

In receiving analog broadcasting, a selection signal for receiving an analog modulation wave is input from the external terminal T20. Then, the control line selection circuit 21 performs a switching operation such that one switching circuit separates the control terminal T18 from the demodulation circuit 13 and the other switching circuit connects the control terminal T18 with the PLL circuit 7, thereby making the gain control line selective.

In addition, the power control circuit 22 performs a switching operation such that a switching circuit thereof separates the circuit, which is configured to include the intermediate frequency amplifier 9 and the mixer 10, from the power line VDD, and the power control circuit 23 performs a switching operation such that a switching circuit thereof separates the demodulation circuit 13 from the power line VDD. In addition, the gain control line selection circuit 15 performs a switching operation such that the switching circuit connects the external terminal T19, the high frequency amplifier (high frequency amplifying circuit) 3, and the intermediate frequency amplifier 9 with each other, thereby making the gain control line selective.

Through the switching operations, the operation of the PLL circuit 7 is controlled by a control signal directly input from the control terminal T18, and the gain of the high frequency amplifier 3 and the gain of the intermediate frequency amplifier 9 are controlled by an external gain control signal input from the external terminal T19. In addition, the circuit configured to include the intermediate frequency amplifier 9 and the mixer 10 and the demodulation circuit 13 stop operating when application of power supply voltage is stopped (when a power supply is turned off).

Accordingly, since a frequency conversion circuit including the PLL circuit 7 and the high frequency amplifier 3 do not use the control signal and the gain control signal output from the demodulation circuit 13, a noise generated due to a clock signal and the like is not mixed from the demodulation circuit 13. As a result, an interfering wave generated in receiving analog broadcasting can be reduced.

Next, in receiving digital broadcasting, a selection signal for receiving a digital modulation wave is input from the external terminal T20. Then, the control line selection circuit 21 performs a switching operation such that one switching circuit connects the control terminal T18 with the demodulation circuit 13 and the other switching circuit connects the demodulation circuit 13 with the PLL circuit 7, thereby making the gain control line selective.

In addition, the power control circuit 22 performs a switching operation such that the switching circuit connects the circuit, which is configured to include the intermediate frequency amplifier 9 and the mixer 10, with the power line VDD, and the power control circuit 23 performs a switching operation such that the switching circuit connects the demodulation circuit 13 with the power line VDD. In addition, the gain control line selection circuit 15 performs a switching operation such that the switching circuit connects the demodulation circuit 13, the high frequency amplifier 3, and the intermediate frequency amplifier 9 with each other, thereby making the gain control line selective.

Through the switching operations, a power supply voltage is applied (a power supply is turned on) to the circuit configured to include the intermediate frequency amplifier 9 and the mixer 10 and the demodulation circuit 13, and the control signal and the gain control signal output from the demodulation circuit 13 are supplied to a required circuit through the control line and the gain control line. Therefore, in the same manner as in the related art, the operation of the PLL circuit 7 is controlled by the control signal output from the demodulation circuit 13, and the gain of the high frequency amplifier 3 and the gain of the intermediate frequency amplifier 9 are controlled by the gain control signal output from the demodulation circuit 13.

### SUMMARY

In the known broadcasting receiver 1, however, the demodulation circuit 13 transmits and receives control data on a control line between the demodulation circuit 13 and the control terminals T18 through the control line selection circuit 21 when receiving digital broadcasting. Accordingly, if the control line selection circuit 21 is switched or the demodulation circuit 13 is separated from the power line VDD while the control data is being transmitted or received, there has been a problem that the control line freezes to make transmission and reception of control data difficult even if the demodulation circuit 13 is driven again by supply of power to the demodulation circuit 13.

An advantage of some aspects of the invention is that it provides a signal receiver capable of stopping an operation of a digital demodulation circuit at the time of analog reception without affecting an operation of the digital demodulation circuit when the digital demodulation circuit is driven again, a control method thereof, and a signal receiving module.

According to an aspect of the invention, a signal receiver includes: a receiving unit that receives an analog modulation signal and a digital modulation signal; a digital demodulation circuit that demodulates the digital modulation signal; a first control circuit that performs communication with the digital demodulation circuit through a first dedicated control line; and a second control circuit that performs communication with the first control circuit through a second dedicated control line. The second control circuit stops the communication between the digital demodulation circuit and the first control circuit before switching from reception of the digital modulation signal to reception of the analog modulation signal and stops supply of power to the digital demodulation circuit after checking through the second dedicated control line that the communication has stopped.

According to this configuration, since the communication between the digital demodulation circuit and the first control circuit is stopped before supply of power to the digital demodulation circuit is stopped, stopping of the supply of power to the digital demodulation circuit during the communication can be prevented.

In the signal receiver according to the aspect of the invention, it is preferable to further include a third dedicated control line that connects the receiving unit and the digital demodulation circuit with each other and a switching circuit that is provided on the third dedicated control line and connects the third dedicated control line to the second control circuit. In addition, preferably, the second control circuit controls the receiving unit through the second control line, the first control line, and the third dedicated control line in receiving the digital modulation signal and controls the receiving unit directly through the third dedicated control line in receiving the analog modulation signal by controlling the switching circuit.

According to this configuration, although the supply of power to the digital demodulation circuit is stopped when receiving the analog modulation signal, it becomes possible to control the receiving unit by means of the second control circuit by connecting the second control circuit and the receiving unit with each other through the third dedicated control line.

In the signal receiver according to the aspect of the invention, preferably, the second control circuit makes the power supplied to the digital demodulation circuit so that preparation for the communication between the digital demodulation circuit and the first control circuit is completed before switching from reception of the analog modulation signal to reception of the digital modulation signal and starts the communication between the digital demodulation circuit and the first control circuit after checking through the second dedicated control line that the preparation has been completed.

According to this configuration, when the power is supplied to the digital demodulation circuit, the communication is started after checking that preparation for the communication between the digital demodulation circuit and the first control circuit has been completed. Therefore, the communication between the digital demodulation circuit and the first control circuit can be started after the digital demodulation circuit has been driven surely.

In the signal receiver according to the aspect of the invention, preferably, the first control circuit includes an MPEG decoder. In this case, a signal demodulated by the digital demodulation circuit can be reliably decoded by the MPEG decoder.

According to another aspect of the invention, a control method of a signal receiver having a receiving unit that receives an analog modulation signal and a digital modulation signal, a digital demodulation circuit that demodulates the digital modulation signal, a first control circuit that performs communication with the digital demodulation circuit through a first dedicated control line, and a second control circuit that performs communication with the first control circuit through a second dedicated control line includes the steps of: stopping the communication between the digital demodulation circuit and the first control circuit before switching from reception of the digital modulation signal to reception of the analog modulation signal; and stopping supply of power to the digital demodulation circuit after the second control circuit checks through the second dedicated control line that the communication has stopped.

According to this method, since the communication between the digital demodulation circuit and the first control circuit is stopped before supply of power to the digital demodulation circuit is stopped, stopping of the supply of power to the digital demodulation circuit during the communication can be prevented.

Preferably, the control method of a signal receiver according to the aspect of the invention further includes the steps of: stopping the communication between the digital demodulation circuit and the first control circuit by transmitting a change command from the second control circuit to the first control circuit and the digital demodulation circuit; causing the first control circuit to check through the second dedicated control line whether or not the communication between the digital demodulation circuit and the first control circuit has stopped by means of the second control circuit; and stopping supply of power to the digital demodulation circuit after the checking.

According to this method, even if the communication between the digital demodulation circuit and the first control circuit is stopped, communication between the second control circuit and the first control circuit can be performed through the second dedicated control line. Thus, the second control circuit can make the supply of power to the digital demodulation circuit stopped after the communication has stopped surely by asking the first control circuit whether or not the communication between the digital demodulation circuit and the first control circuit has stopped.

Preferably, the control method of a signal receiver according to the aspect of the invention further includes the steps of: supplying the power to the digital demodulation circuit so that preparation for the communication between the digital demodulation circuit and the first control circuit is completed before switching from reception of the analog modulation signal to reception of the digital modulation signal; and starting the communication between the digital demodulation circuit and the first control circuit after the second control circuit checks through the second dedicated control line that the preparation has been completed.

According to this method, when the power is supplied to the digital demodulation circuit, the communication is started after checking that preparation for the communication between the digital demodulation circuit and the first control circuit has been completed. Therefore, the communication between the digital demodulation circuit and the first control circuit can be started after the digital demodulation circuit has been driven surely.

According to still another aspect of the invention, a signal receiving module includes: a receiving unit that receives an analog modulation signal or a digital modulation signal; a digital demodulation circuit that demodulates the digital modulation signal; and a first control circuit that is connected to the digital demodulation circuit through a first dedicated control line so that communication between the first control circuit and the digital demodulation circuit is performed and is connected to a second control circuit provided outside the module through a second dedicated control line so that communication between the first control circuit and the second control circuit is performed. The communication between the digital demodulation circuit and the first control circuit is stopped before switching from reception of the analog modulation signal to reception of the digital modulation signal, and supply of power to the digital demodulation circuit is stopped after it is notified to the second control circuit through the second dedicated control line that the communication has stopped.

According to this configuration, since the communication between the digital demodulation circuit and the first control circuit is stopped before supply of power to the digital demodulation circuit is stopped, stopping of the supply of power to the digital demodulation circuit during the communication can be prevented.

Preferably, the signal receiving module according to the aspect of the invention further includes: a third dedicated control line that connects the receiving unit and the digital demodulation circuit with each other; and a switching circuit that is provided on the third dedicated control line and connects the third dedicated control line to the second control circuit. In addition, preferably, by switching of the switching circuit, the second control circuit and the receiving unit are connected to each other through the second control line, the first control line, and the third dedicated control line in receiving the digital modulation signal, and the second control circuit and the receiving unit are connected to each other through the third dedicated control line in receiving the analog modulation signal.

According to this configuration, although the supply of power to the digital demodulation circuit is stopped when receiving the analog modulation signal, it becomes possible to control the receiving unit by means of the second control circuit by connecting the second control circuit and the receiving unit with each other through the third dedicated control line.

In the signal receiving module according to the aspect of the invention, preferably, the power is supplied to the digital demodulation circuit before switching from reception of the analog modulation signal to reception of the digital modulation signal so that preparation for the communication between the digital demodulation circuit and the first control circuit is completed, and the communication between the digital demodulation circuit and the first control circuit is started after it is notified to the second control circuit through the second dedicated control line that the preparation has been completed.

According to this configuration, when the power is supplied to the digital demodulation circuit, the communication is started after checking that preparation for the communication between the digital demodulation circuit and the first control circuit has been completed. Therefore, the communication between the digital demodulation circuit and the first control circuit can be started after the digital demodulation circuit has been driven surely.

In the signal receiving module according to the aspect of the invention, preferably, the first control circuit includes an MPEG decoder. In this case, a signal demodulated by the digital demodulation circuit can be reliably decoded by the MPEG decoder.

According to the aspects of the invention, it is possible to provide a signal receiver capable of stopping an operation of a digital demodulation circuit at the time of analog reception without affecting an operation of the digital demodulation circuit when the digital demodulation circuit is driven again, a control method thereof, and a signal receiving module.

### BRIEF DESCRIPTION OF THE DRAWINGS

Fig. 1 is a block diagram showing a television signal receiver according to an embodiment of the invention;
Fig. 2 is a flow chart explaining a switching operation of the television signal receiver shown in Fig. 1 from digital reception to analog reception;
Fig. 3 is a flow chart explaining a switching operation of the television signal receiver shown in Fig. 1 from analog reception to digital reception; and
Fig. 4 is a block diagram showing the configuration of a known broadcasting receiver.

### DESCRIPTION OF EXEMPLARY EMBODIMENTS

Hereinafter, a signal receiver according to an embodiment of the invention will be described in detail with reference to the accompanying drawings.

### (First embodiment)

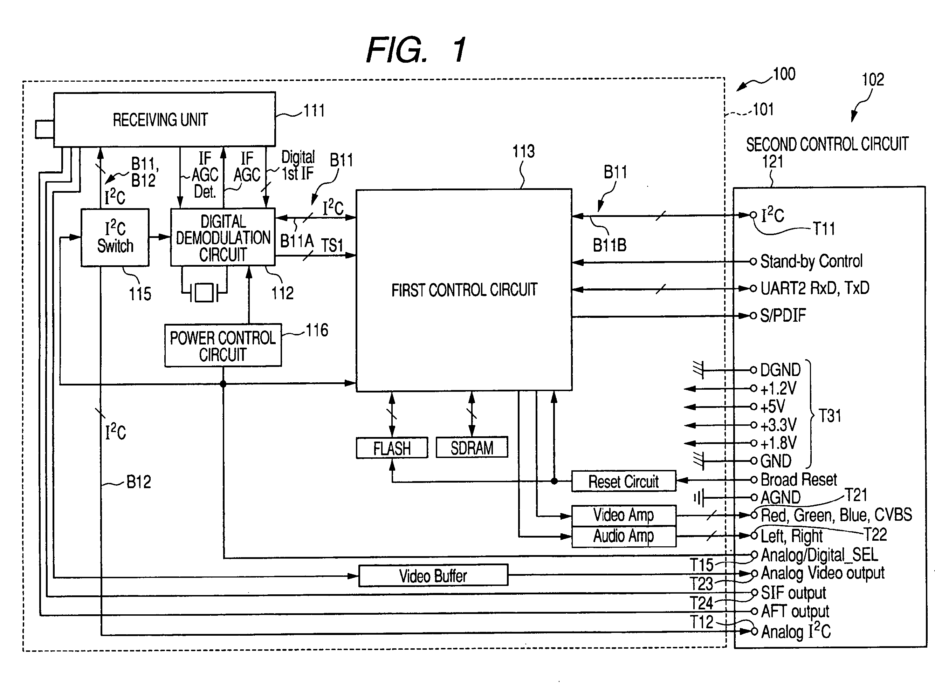

Fig. 1 is a block diagram showing a television signal receiver 100 according to an embodiment of the invention. The television signal receiver 100 includes a television signal receiving module 101 and a host section 102.

The television signal receiving module 101 has a receiving unit 111 that receives an analog modulation television signal (hereinafter, referred to as an analog broadcast signal) and a digital modulation television signal (hereinafter, referred to as a digital broadcast signal), a digital demodulation circuit 112 that demodulates the received digital broadcast signal, and a first control circuit 113 that performs MPEG (moving picture experts group) decoding of the demodulated digital broadcast signal.

The host section 102 includes: a control terminal T11 for outputting to the receiving unit 111, the digital demodulation circuit 112, and the first control circuit 113 control data for controlling the receiving unit 111, the digital demodulation circuit 112, and the first control circuit 113 when a digital broadcast signal is received; a control terminal T12 for outputting control data to the receiving unit 111 when an analog broadcast signal is received; digital output terminals T21 and T22 for receiving and outputting a digital video signal and a digital audio signal, which are obtained by decoding the digital broadcast signal in the first control circuit 113; analog output terminals T23 and T24 for receiving and outputting analog broadcast signals (an analog video signal and an analog audio signal) obtained from the receiving unit 111; and a power terminal T31 for supplying power to the television signal receiving module 101.

The control terminal T11 for controlling the reception of a digital broadcast signal is connected to the first control circuit 113, the digital demodulation circuit 112, and the receiving unit 111 through an I²C (inter integrated circuit) bus. In the present embodiment, I²C buses for controlling the reception of a digital broadcast signal among a second control circuit 121, the first control circuit 113, the digital demodulation circuit 112, and the receiving unit 111 are collectively called digital reception control buses. Among the digital reception control buses, particularly the I²C bus between the second control circuit 121 and the first control circuit 113 is called a second dedicated control line B11B, and the I²C bus between the first control circuit 113 and the digital demodulation circuit 112 is called a first dedicated control line B11A. In addition, the I²C bus which connects between the digital demodulation circuit 112 and the receiving unit 111 through a bus switching circuit 115 is called a third dedicated control line. The third dedicated control line is also connected to the control terminal T12 for receiving an analog signal from the bus switching circuit 115.

That is, the control terminal T12 for controlling the reception of an analog broadcast signal is connected to the receiving unit 111 through an I²C (inter integrated circuit) bus (hereinafter, referred to as an analog reception control bus) B12 that forms an analog control extension line of the third dedicated control line. In addition, either a digital reception control bus B11 or the analog reception control bus B12 is selected by the bus switching circuit (I²C switch) 115 and is connected to the receiving unit 111.

That is, a selection terminal T15 for selecting either the analog reception control bus B12 or the digital reception control bus B11 is provided in the second control circuit 121, and the bus switching circuit 115 is connected to the selection terminal T15. Accordingly, the bus switching circuit 115 selects the analog reception control bus B12 when an analog control command for selecting analog reception is input to the selection terminal T15, and the bus switching circuit 115 selects the digital reception control bus B11 when a digital control command for selecting digital reception is input.

In addition, a power control circuit 116 is connected to the selection terminal T15. The power control circuit 116 stops supply of power to the digital demodulation circuit 112 when the analog control command for selecting analog reception is input from the selection terminal T15, while the power control circuit 116 makes the power supplied to the digital demodulation circuit 112 when the digital control command for selecting digital reception is input.

In the configuration described above, in case of receiving a digital broadcast signal, the bus switching circuit 115 selects the digital reception control bus B11 in response to a digital control command input to the selection terminal T15. Then, the control terminal T11 for controlling the reception of a digital broadcast signal, the first control circuit 113, the digital demodulation circuit 112, and the receiving unit 111 are connected by the digital reception control bus B11. As a result, control data can be transmitted and received between the control terminal T11 and the receiving unit 111. In this case, the digital demodulation circuit 112 performs receiving processing (demodulation processing) while performing communication between the digital demodulation circuit 112 and the first control circuit 113 through the first dedicated control line B11A.

On the other hand, in case of receiving an analog broadcast signal, the bus switching circuit 115 selects the analog reception control bus B12 in response to an analog control command input to the selection terminal T15. Then, the control terminal T12 for controlling the reception of an analog broadcast signal and the receiving unit 111 are connected by the analog reception control bus B12. As a result, control data can be transmitted and received between the control terminal T12 and the receiving unit 111. Thus, in case of receiving an analog broadcast signal, control data can be transmitted directly to the receiving unit 111 through the analog reception control bus B12 without the digital demodulation circuit 112. That is, in case of receiving the analog broadcast signal, an operation of the digital demodulation circuit 112 is not required. Therefore, in case of receiving the analog broadcast signal, the television signal receiver 100 stops the operation of the digital demodulation circuit 112 so that supply of power to the digital demodulation circuit 112 is stopped.

As a result, in case of receiving the analog broadcast signal, it can be reduced that a noise related with the operation of the digital demodulation circuit 112 is mixed in a received signal when receiving the analog broadcast signal.

In this case, in the television signal receiver 100, communication performed between the digital demodulation circuit 112 and the first control circuit 113 through the first dedicated control line B11A is interrupted according to a predetermined rule when stopping supply of power to the digital demodulation circuit 112, such that the communication performed between the digital demodulation circuit 112 and the first control circuit 113 through the first dedicated control line B11A normally starts when the power is supplied to the digital demodulation circuit 112 (when the digital demodulation circuit 112 is driven again).

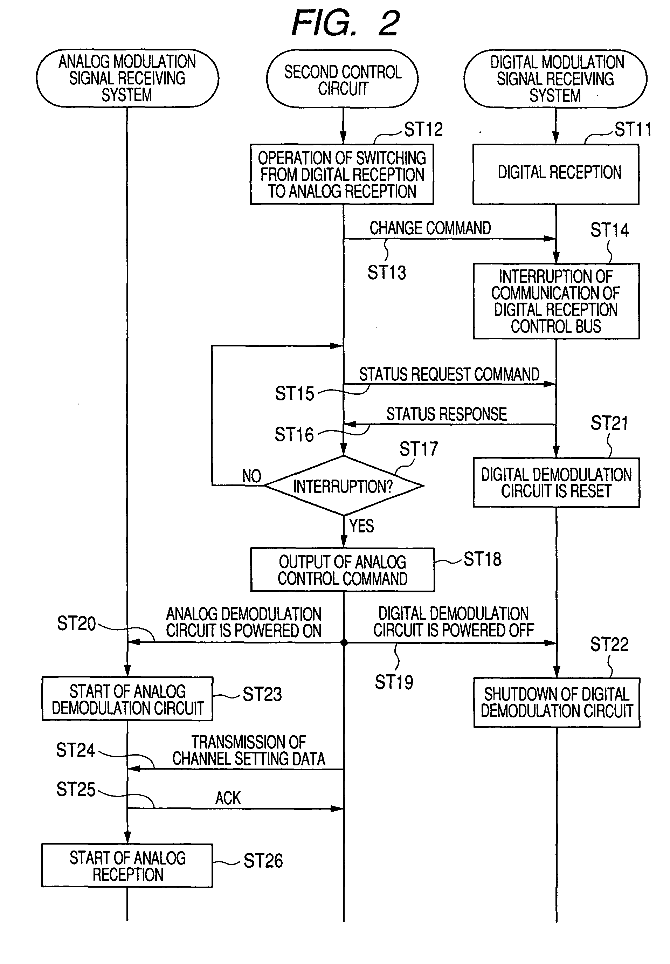

That is, Fig. 2 is a flow chart showing operations of a digital modulation signal receiving system, an analog modulation signal receiving system, and the second control circuit 121 in the case of switching from a state (digital reception) of receiving a digital broadcast signal to a state (analog reception) of receiving an analog broadcast signal. In addition, the digital modulation signal receiving system means a circuit (for example, the receiving unit 111 and the digital demodulation circuit 112) operating in order to receive a digital modulation signal (digital broadcast signal), and the analog modulation signal receiving system means a circuit (for example, the receiving unit 111 and an analog modulation circuit (not shown)) operating in order to receive an analog modulation signal (analog broadcast signal).

As shown in Fig. 2, while a digital broadcast signal is being received in the television signal receiver 100 (step ST11), for example, when a user performs an operation for selecting reception of an analog broadcast signal (step ST12), a command (change command) that instructs a change from digital reception to analog reception is transmitted from the second control circuit 121 to the digital modulation signal receiving system (the digital demodulation circuit 112 and the first control circuit 113) through the digital reception control bus B11 (the second dedicated control line B11B and the first dedicated control line B11A (step ST13).

The digital demodulation circuit 112 and the first control circuit 113 that have received the change command interrupt the communication performed therebetween through the first dedicated control line B11A. That is, the digital demodulation circuit 112 and the first control circuit 113 interrupt the communication according to a predetermined interruption rule (step ST14). Then, it is prevented that supply of power to the demodulation circuit 112 is stopped while communication of the control command is being performed between the first control circuit 113 and the digital demodulation circuit 112.

In addition, even if the communication performed between the first control circuit 113 and the digital demodulation circuit 112 through the first dedicated control line B11A is interrupted, communication performed between the first control circuit 113 and the second control circuit 121 through the second dedicated control line B11 B is not interrupted such that a communicable state is maintained between the first control circuit 113 and the second control circuit 121. Accordingly, through the second dedicated control line B11B provided between the first control circuit 113 and the second control circuit 121, the second control circuit 121 transmits to the digital modulation signal receiving system (first control circuit 113) a status request command asking whether or not the communication between the first control circuit 113 and the digital demodulation circuit 112 has been interrupted according to the predetermined interruption rule (step ST15).

When the communication between the first control circuit 113 and the digital demodulation circuit 112 has been interrupted normally, the first control circuit 113 that has received the status request command notifies the second control circuit 121 that the communication has been interrupted normally by transmitting a status response (step ST16). The second control circuit 121 repeats transmission of the status request command until the status response is returned from the first control circuit 113. In addition, a case in which the second control circuit 121 receives the status response from the first control circuit 113 means that the communication between the first control circuit 113 and the digital demodulation circuit 112 has been interrupted normally. In this case, the second control circuit 121 acquires a positive result in step ST17, proceeding to step ST18 in which an analog control command is output from the selection terminal T15 of the second control circuit 121 to the power control circuit 116 and the bus switching circuit 115.

The bus switching circuit 115 that has received the analog control command switches from the digital reception control bus B11 to the analog reception control bus B12 to thereby connect the analog reception control terminal T12 and the receiving unit 111 with each other. This allows communication for analog reception to be performed between the control terminal T12 and the receiving unit 111 through the analog reception control bus B12. In addition, the power control circuit 116 that has received the analog control command stops supply of power to the digital demodulation circuit 112 (step ST19) and starts supply of power to an analog demodulation circuit 112 (not shown) (step ST20). Thus, in the second control circuit 121, it is possible to prevent supply of power to the digital demodulation circuit 112 from being stopped while the communication between the first control circuit 113 and the digital demodulation circuit 112 is being performed by stopping the supply of power to the digital demodulation circuit 112 on the condition that the communication between the first control circuit 113 and the digital demodulation circuit 112 has been interrupted normally in the determination of step S17. As a result, the communication between the digital demodulation circuit 112 and the first control circuit 113 starts normally when the power is supplied to the digital demodulation circuit 112 again.

On the other hand, the digital demodulation circuit 112 in the digital modulation signal receiving system is reset to be initialized after the status response is transmitted to the second control circuit 121 (step ST16). Then, when the supply of power is stopped by the control of the second control circuit 121 (step ST19), the digital demodulation circuit 112 becomes in a shutdown state (step ST22).

On the other hand, in the analog modulation signal receiving system, when the supply of power is started by the control of the second control circuit 121 (step ST20), the analog demodulation circuit (not shown) is driven (step ST23). Then, when channel setting data is transmitted from the control terminal T12 of the second control circuit 121 to the receiving unit 111 in response to a user's selection operation or the like (step ST24), a response signal (Acknowledge) is transmitted from the receiving unit 111 to the second control circuit 121 (step ST25) and reception (analog reception) of an analog broadcast signal is started (step ST26).

Furthermore, in the television signal receiver 100, when a digital receiving state switches to an analog receiving state, supply of power to the digital demodulation circuit 112 is stopped after the communication performed between the digital demodulation circuit 112 and the first control circuit 113 through the first dedicated control line B11A has been interrupted normally according to the predetermined interruption rule. This prevents the digital demodulation circuit 112 from being shut down during the communication between the digital demodulation circuit 112 and the first control circuit 113. For example, occurrence of an unfavorable situation in which the digital demodulation circuit 112 is shut down before transmission of the response after the control command is transmitted from the first control circuit 113 to the digital demodulation circuit 112 to thereby freeze the first dedicated control line B11A can be prevented beforehand.

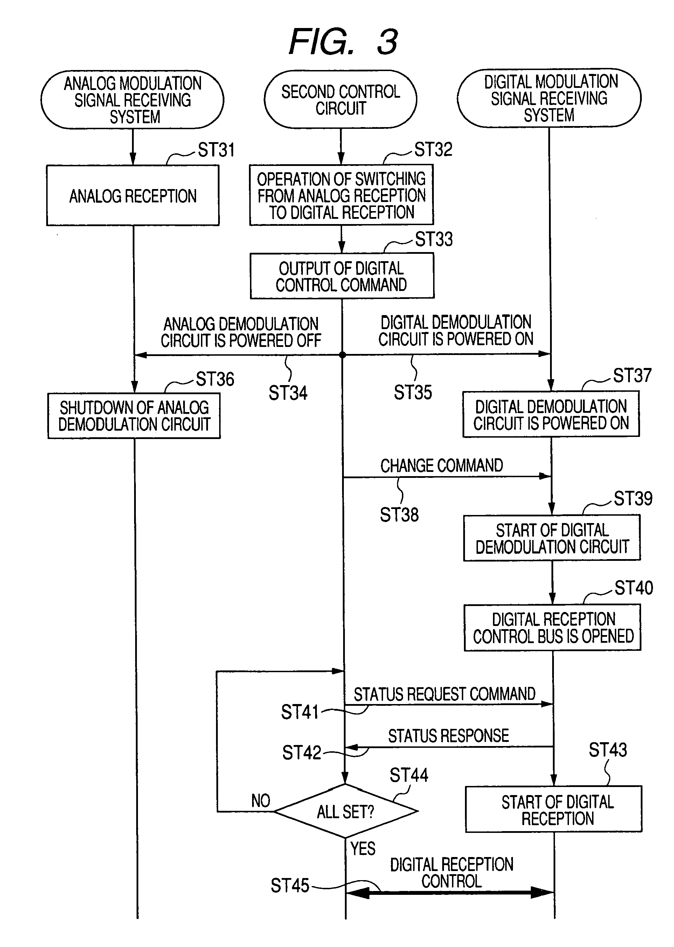

In addition, Fig. 3 is a flow chart showing operations of the digital modulation signal receiving system, the analog modulation signal receiving system, and the second control circuit 121 in the case of switching from a state (analog reception) of receiving an analog broadcast signal to a state (digital reception) of receiving a digital broadcast signal.

As shown in Fig. 3, while an analog broadcast signal is being received in the television signal receiver 100 (step ST31), for example, when a user performs an operation of selecting reception of a digital broadcast signal (step ST32), a digital control command is output from the selection terminal T15 of the second control circuit 121 to the digital modulation signal receiving system (the bus switching circuit 115, the power supply circuit 116, and the digital demodulation circuit 112) (step ST33).

The bus switching circuit 115 that has received the digital control command switches from the analog reception control bus B12 to the digital reception control bus B11 to thereby connect the digital reception control terminal T11 and the receiving unit 111 with each other through the digital reception control bus B11. In addition, the power control circuit 116 that has received the digital control command stops supply of power to the analog demodulation circuit (not shown) (step ST34) and starts supply of power to the digital demodulation circuit 112 (step ST35). As a result, the analog demodulation circuit is shut down (step ST36), and the power is supplied to the digital demodulation circuit 112 (step ST37).

Then, the second control circuit 121 transmits a command (change command), which instructs a change from analog reception to digital reception, from the control terminal T11 to the first control circuit 113 through the second dedicated control line B11B (step ST38). This makes the first control circuit 113 and the digital demodulation circuit 112 driven (step ST39). Then, communication between the digital demodulation circuit 112 and the first control circuit 113 can be started (step ST40).

Then, the second control circuit 121 transmits a status request command to the first control circuit 113 through the second dedicated control line B11 B provided between the second control circuit 121 and the first control circuit 113 (step ST41) in order to ask whether or not the communication performed between the first control circuit 113 and the digital demodulation circuit 112 through the first dedicated control line B11A can be started. When the digital demodulation circuit 112 starts normally to make preparation for the start of communication between the digital demodulation circuit 112 and the first control circuit 113 completed, a status response is transmitted from the first control circuit 113 to the second control circuit 121 (step ST42). In the digital modulation signal receiving system (the digital demodulation circuit 112 and the first control circuit 113), digital reception is started after transmitting the status response (step ST43).

The second control circuit 121 determines whether or not the status response has been transmitted from the first control circuit 113 (step ST44) and repeats transmission of the status request command until the status response is transmitted. Then, when the status response is transmitted from the first control circuit 113 to the second control circuit 121, the second control circuit 121 acquires a positive result in step ST44 to start communication for digital reception control between the second control circuit 121 and the digital modulation signal receiving system (the first control circuit 113 and the digital demodulation circuit 112) (step ST45).

Thus, in the television signal receiver 100, for example, an unfavorable situation in which the communication starts in a state where the power is supplied but preparation for communication is not completed can be prevented by starting the communication after the preparation for communication between the digital demodulation circuit 112 and the first control circuit 113 is completed, without allowing the communication between the digital demodulation circuit 112 and the first control circuit 113 to start only by starting the supply of power to the digital demodulation circuit 112.

In addition, according to the television signal receiver 100 described above, the communication between the digital demodulation circuit 112 and the first control circuit 113 can be normally interrupted by processing based on the processing interruption rule in the configuration of stopping the operation of the digital demodulation circuit 112 at the time of analog reception. Accordingly, the communication between the digital demodulation circuit 112 and the first control circuit 113 can be restarted normally later.

### (Other embodiments)

In the above embodiment, a case where the I²C buses are used as the first dedicated control line B11A and the second dedicated control line B11B has been described. However, the invention is not limited to the case, but various kinds of buses may also be used.

Furthermore, in the above embodiment, a case where the invention is applied to the television signal receiver 100 that receives a television signal, which is an example of a signal receiver, has been described. However, a received signal is not limited to a television signal, but the invention may be widely applied to cases of receiving other kinds of signals.

It should be understood by those skilled in the art that various modifications, combinations, sub-combinations and alternations may occur depending on design requirements and other factors insofar as they are within the scope of the appended claims of the equivalents thereof.

### INDUSTRIAL APPLICABILITY

The invention may be applied to a television broadcast signal receiver, for example.

## Claims

1. A signal receiver (100) comprising:
a receiving unit (111) that receives an analog modulation signal and a digital modulation signal;
a digital demodulation circuit (112) that demodulates the digital modulation signal;
a first control circuit (113) that performs communication with the digital demodulation circuit (112) through a first dedicated control line (B11A); and
a second control circuit (121) that performs communication with the first control circuit (113) through a second dedicated control line (B11B),
wherein the second control circuit (121) stops the communication between the digital demodulation circuit (112) and the first control circuit (113) before switching from reception of the digital modulation signal to reception of the analog modulation signal and stops supply of power to the digital demodulation circuit (112) after checking through the second dedicated control line (B11B) that the communication has stopped.

2. The signal receiver (100) according to claim 1, further comprising:
a third dedicated control line that connects the receiving unit (111) and the digital demodulation circuit (112) with each other; and
a switching circuit that is provided on the third dedicated control line and connects the third dedicated control line to the second control circuit (121),
wherein the second control circuit (121) controls the receiving unit (111) through the second control line (B11B), the first control line (B11A), and the third dedicated control line in receiving the digital modulation signal and controls the receiving unit (111) directly through the third dedicated control line in receiving the analog modulation signal by controlling the switching circuit.

3. The signal receiver (100) according to claim 1 or 2,
wherein the second control circuit (121) makes the power supplied to the digital demodulation circuit (112) so that preparation for the communication between the digital demodulation circuit (112) and the first control circuit (113) is completed before switching from reception of the analog modulation signal to reception of the digital modulation signal and starts the communication between the digital demodulation circuit (112) and the first control circuit (113) after checking through the second dedicated control line (B11B) that the preparation has been completed.

4. The signal receiver (100) according to any one of claims 1 to 3,
wherein the first control circuit (113) includes an MPEG decoder.

5. A control method of a signal receiver (100) having a receiving unit (111) that receives an analog modulation signal and a digital modulation signal, a digital demodulation circuit (112) that demodulates the digital modulation signal, a first control circuit (113) that performs communication with the digital demodulation circuit (112) through a first dedicated control line (B11A), and a second control circuit (121) that performs communication with the first control circuit (113) through a second dedicated control line (B11B), the control method comprising the steps of:
stopping the communication between the digital demodulation circuit (112) and the first control circuit (113) before switching from reception of the digital modulation signal to reception of the analog modulation signal; and
stopping supply of power to the digital demodulation circuit (112) after the second control circuit (121) checks through the second dedicated control line (B11 B) that the communication has stopped.

6. The control method of a signal receiver (100) according to claim 5, further comprising the steps of:
stopping the communication between the digital demodulation circuit (112) and the first control circuit (113) by transmitting a change command from the second control circuit (121) to the first control circuit (113) and the digital demodulation circuit (112);
causing the first control circuit (113) to check through the second dedicated control line (B11B) whether or not the communication between the digital demodulation circuit (112) and the first control circuit (113) has stopped by means of the second control circuit (121); and
stopping supply of power to the digital demodulation circuit (112) after the checking.

7. The control method of a signal receiver (100) according to claim 5 or 6, further comprising the steps of:
supplying the power to the digital demodulation circuit (112) so that preparation for the communication between the digital demodulation circuit (112) and the first control circuit (113) is completed before switching from reception of the analog modulation signal to reception of the digital modulation signal; and
starting the communication between the digital demodulation circuit (112) and the first control circuit (113) after the second control circuit (121) checks through the second dedicated control line (B11B) that the preparation has been completed.

8. A signal receiving module comprising:
a receiving unit (111) that receives an analog modulation signal or a digital modulation signal;
a digital demodulation circuit (112) that demodulates the digital modulation signal; and
a first control circuit (113) that is connected to the digital demodulation circuit (112) through a first dedicated control line (B11A) so that communication between the first control circuit (113) and the digital demodulation circuit (112) is performed and is connected to a second control circuit (121) provided outside the module through a second dedicated control line (B11B) so that communication between the first control circuit (113) and the second control circuit (121) is performed,
wherein the communication between the digital demodulation circuit (112) and the first control circuit (113) is stopped before switching from reception of the analog modulation signal to reception of the digital modulation signal, and supply of power to the digital demodulation circuit (112) is stopped after it is notified to the second control circuit (121) through the second dedicated control line (B11B) that the communication has stopped.

9. The signal receiving module according to claim 8, further comprising:
a third dedicated control line that connects the receiving unit (111) and the digital demodulation circuit (112) with each other; and
a switching circuit that is provided on the third dedicated control line and connects the third dedicated control line to the second control circuit (121),
wherein by switching of the switching circuit, the second control circuit (121) and the receiving unit (111) are connected to each other through the second control line (B11B), the first control line (B11A), and the third dedicated control line in receiving the digital modulation signal, and the second control circuit (121) and the receiving unit (111) are connected to each other through the third dedicated control line in receiving the analog modulation signal.

10. The signal receiving module according to claim 8 or 9,
wherein the power is supplied to the digital demodulation circuit (112) before switching from reception of the analog modulation signal to reception of the digital modulation signal so that preparation for the communication between the digital demodulation circuit (112) and the first control circuit (113) is completed, and
the communication between the digital demodulation circuit (112) and the first control circuit (113) is started after it is notified to the second control circuit (121) through the second dedicated control line (B11B) that the preparation has been completed.

11. The signal receiving module according to any one of claims 8 to 10,
wherein the first control circuit (113) includes an MPEG decoder.
